# EUROPEAN PATENT APPLICATION

(11) **EP 4 592 133 A1**
(43) Date of publication of application: **30.07.2025**
(21) Application number: 23878661.0
(22) Date of filing: 19.06.2023
(51) Int. Cl.: B60L 53/302, H05K 7/20, G06F 1/20

(54) **CHARGING APPARATUS AND CHARGING SYSTEM**

(30) Priority: 19.10.2022 CN 202211282017
(71) Applicant: Huawei Digital Power Technologies Co., Ltd., Shenzhen, Guangdong 518043 (CN)
(72) Inventor: GAO, Qiang, Shenzhen, Guangdong 518043 (CN); QIU, Yongqi, Shenzhen, Guangdong 518043 (CN)
(74) Representative: Epping - Hermann - Fischer
(86) International application number: PCT/CN2023/101062
(87) International publication number: WO 2024/082664

(57) **Abstract**

This application provides a charging device and a charging system, and relates to the field of energy technologies, to resolve problems such as a complex heat dissipation structure and high costs in a charging device. The charging device provided in this application includes a composite heat exchanger, a first electronic component, a second electronic component, and a housing. The composite heat exchanger includes a first heat exchange body and a second heat exchange body. The first heat exchange body has a heat conduction part and a heat dissipation part. The second heat exchange body has an evaporation end and a condensation end. The second heat exchange body has a cavity. A cooling medium is disposed in the cavity. The cooling medium may circulate between the evaporation end and the condensation end. The first electronic component is connected to the heat conduction part in a thermally conductive manner. The second electronic component is connected to the evaporation end in the thermally conductive manner. The housing is connected to the heat conduction part and the evaporation end, to form an airtight accommodating cavity. Both the first electronic component and the second electronic component are located in the accommodating cavity. The charging device provided in this application has advantages such as a simple structure and good heat dissipation effect, and can ensure airtightness of the first electronic component and the second electronic component.

## Description

### CROSS-REFERENCE TO RELATED APPLICATIONS

This application claims priority to Chinese Patent Application No. 202211282017.1, filed with the China National Intellectual Property Administration on October 19, 2022 and entitled "CHARGING DEVICE AND CHARGING SYSTEM", which is incorporated herein by reference in its entirety.

### TECHNICAL FIELD

This application relates to the field of energy technologies, and in particular, to a charging device and a charging system.

### BACKGROUND

With continuous development and popularization of new energy vehicles, increasingly more charging devices are also deployed. A charging device usually includes a plurality of different types of electrical components. Some electronic components generate a large amount of heat during operation. To ensure that the charging device is within a normal operating temperature range, heat dissipation usually needs to be performed on the some electronic components in the charging device. Currently, air cooling and liquid cooling are usually used to dissipate heat for an electronic component. In the air cooling manner, a fan is generally used to generate an airflow, and the airflow quickly passes through a surface of a heat generating device, to take away heat. However, in this manner, impurities such as dust are easily accumulated on the surface of the electronic component, and this affects reliability and a service life of the electronic component. The liquid cooling manner has high requirements on airtightness and reliability of a liquid cooling pipe, and has problems such as a complex structure, high construction difficulty, and high costs.

### SUMMARY

This application provides a charging device that features a simple structure and cost-effectiveness and can implement a high ingress protection rating, and a charging system.

According to a first aspect, this application provides a charging device. The charging device may include a composite heat exchanger, a first electronic component, a second electronic component, and a housing. The composite heat exchanger includes a first heat exchange body and a second heat exchange body that are fastened. The first heat exchange body has a heat conduction part and a heat dissipation part. The first electronic component is connected to the heat conduction part in a thermally conductive manner. Therefore, heat generated by the first electronic component can be transferred to the heat dissipation part via the heat conduction part for heat dissipation, so as to cool the first electronic component. In addition, the second heat exchange body has an evaporation end and a condensation end.

The second heat exchange body has a cavity. A cooling medium is disposed in the cavity. The cooling medium may circulate between the evaporation end and the condensation end. The second electronic component is connected to the evaporation end in the thermally conductive manner. After heat generated by the second electronic component is transferred to the evaporation end, the cooling medium located near the evaporation end in the cavity is evaporated due to the heat, and is condensed due to heat release at the condensation end. In other words, the second heat exchange body implements a heat dissipation function of the second heat exchange body mainly based on the circulation of the cooling medium between the evaporation end and the condensation end. The housing is connected to the heat conduction part and the evaporation end, to form an airtight accommodating cavity. Both the first electronic component and the second electronic component are located in the accommodating cavity, so that airtightness of the first electronic component and the second electronic component can be ensured.

In an example, the heat conduction part is connected to the evaporation end in the thermally conductive manner, to improve heat dissipation efficiency of the composite heat exchanger. For example, in some cases, the heat of the first electronic component may be dissipated via the first heat exchange body and the second heat exchange body. In addition, the heat of the second electronic component may be dissipated via the second heat exchange body and the first heat exchange body. Therefore, a heat dissipation capability of the composite heat exchanger can be effectively used, improving the heat dissipation efficiency of the composite heat exchanger.

During specific disposition, the heat conduction part has a first contact surface, and the evaporation end has a second contact surface. The first electronic component is connected to the first contact surface in the thermally conductive manner. The second electronic component is connected to the second contact surface in the thermally conductive manner.

The first contact surface may be a plane or a curved surface. For example, the first contact surface may have a protrusion or a groove. The first electronic component may be connected to the groove or the protrusion in the thermally conductive manner, to appropriately adapt to the first electronic component of different sizes.

Certainly, during specific disposition, the second contact surface may also be a plane or a curved surface. Alternatively, the second contact surface may have a protrusion or a groove.

The first contact surface and the second contact surface may be disposed adjacent to each other, and the first contact surface and the second contact surface face a same direction. In this way, the first contact surface and the second contact surface can form a roughly flat surface.

Alternatively, in some examples, the first contact surface and the second contact surface may be disposed opposite to each other or disposed at an included angle.

In addition, in some examples, the heat dissipation part of the first heat exchange body may have a first recess part. The condensation end of the second heat exchange body is located in the first recess part, to reduce a volume of the entire composite heat exchanger, and facilitate miniaturization of the composite heat exchanger.

In some examples, the condensation end of the second heat exchange body may have a second recess part. The heat dissipation part of the first heat exchange body is located in the second recess part.

Alternatively, it may be understood that, during disposition, the first heat exchange body and the second heat exchange body may be disposed in a parallel location layout, or may be disposed in a stacked manner.

In addition, the heat dissipation part has a first airflow channel, and the condensation end has a second airflow channel. The charging device may further include a fan. The fan may enable air to flow through the first airflow channel and the second airflow channel quickly, to improve the heat exchange efficiency of the composite heat exchanger.

During specific disposition, the first airflow channel and the second airflow channel are connected, or the first airflow channel and the second airflow channel may be disposed in parallel.

When the first airflow channel is connected to the second airflow channel, the first airflow channel may be located downstream of the second airflow channel. In other words, cooling airflow may first pass through the second airflow channel and then pass through the first airflow channel, to preferentially ensure heat dissipation effect of the second electronic component.

In addition, in some examples, the first electronic component and the second electronic component may alternatively be connected to the housing in the thermally conductive manner. In other words, the heat generated by the first electronic component and the second electronic component may alternatively be dissipated via the housing.

According to a second aspect, this application further provides a charging system. The charging system may include the foregoing charging device and a charging terminal. The charging device may have an output port. The charging terminal may be connected to the output port. Electric energy processed by the charging device may be provided to the charging terminal, to supplement the electric energy to a powered device (like a vehicle).

During specific disposition, the charging device may be disposed on the ground, or may be disposed at a location like on a wall. A specific disposition location and form of the charging device are not limited in this application.

### BRIEF DESCRIPTION OF DRAWINGS

FIG. 1 is a diagram of an application scenario of a charging device according to an embodiment of this application;
FIG. 2 is a diagram of a side structure of a charging device according to an embodiment of this application;
FIG. 3 is a diagram of another side structure of a charging device according to an embodiment of this application;
FIG. 4 is a top view of FIG. 3;
FIG. 5 is a diagram of still another side structure of a charging device according to an embodiment of this application;
FIG. 6 is a top view of FIG. 5;
FIG. 7 is a diagram of yet another side structure of a charging device according to an embodiment of this application;
FIG. 8 is a diagram of a structure of a location layout of a heat dissipation end and a condensation end according to an embodiment of this application;
FIG. 9 is a diagram of an exploded structure of a composite heat exchanger according to an embodiment of this application; and
FIG. 10 is a diagram of a structure of a charging system according to an embodiment of this application.

### DESCRIPTION OF EMBODIMENTS

To make objectives, technical solutions, and advantages of this application clearer, the following further describes this application in detail with reference to accompanying drawings.

To facilitate understanding of a charging device provided in embodiments of this application, the following first describes an application scenario of the charging device.

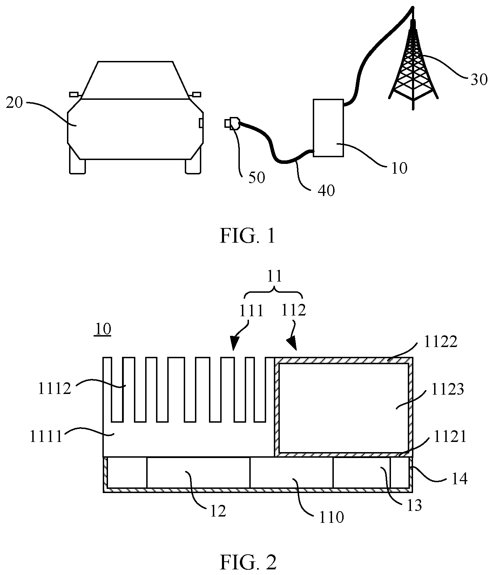

As shown in FIG. 1, in an example provided in this application, a charging device 10 may be used in a scenario in which a vehicle 20 is charged. Specifically, the charging device 10 may specifically be a charging pile, and the charging device 10 may be disposed near a parking space. During actual application, an input end of the charging device 10 may be connected to a power grid 30, and an output end of the charging device 10 may be connected to a charging connector 50 through a cable 40, so as to charge the vehicle 20. Electric energy in the power grid 30 may be industrial electric energy (for example, an alternating current voltage is 380 V), or may be residential electric energy (for example, an alternating current voltage is 22 V), or the like.

During actual application, the charging device 10 may have functions such as overload protection and power conversion. The charging device 10 usually includes electronic components such as a transistor, a transformer, an inductor, a capacitor, or a relay. Some electronic components generate heat during normal operation. To ensure that the charging device 10 is within a normal operating temperature range, heat dissipation usually needs to be performed on the electronic components.

For a current charging device, heat dissipation is generally performed on the charging device in two different manners: air cooling and liquid cooling.

For example, in a charging device using the air cooling manner, a fan is generally used to generate an airflow, and the airflow quickly passes through a surface of an electronic component, to take away heat. However, in this manner, impurities such as dust are easily accumulated on the surface of the electronic component, and this affects reliability and a service life of the electronic component.

In a charging device using the liquid cooling manner, this manner has high requirements on airtightness and reliability of a liquid cooling pipe, and has problems such as a complex structure, high construction difficulty, and high costs. In view of this, embodiments of this application provide a charging device 10 that features a simple structure and cost-effectiveness and can implement a high ingress protection rating, and a charging system in which the charging device 10 is used.

To make objectives, technical solutions, and advantages of this application clearer, the following further describes this application in detail with reference to the accompanying drawings and specific embodiments.

As shown in FIG. 2, in an example provided in this application, the charging device 10 may include a composite heat exchanger 11, a first electronic component 12, a second electronic component 13, and a housing 14. The composite heat exchanger 11 includes a first heat exchange body 111 and a second heat exchange body 112 that are fastened. The first heat exchange body 111 has a heat conduction part 1111 and a heat dissipation part 1112. The first electronic component 12 is connected to the heat conduction part 1111 in a thermally conductive manner. Therefore, heat generated by the first electronic component 12 can be transferred to the heat dissipation part 1112 via the heat conduction part 1111 for heat dissipation, so as to cool the first electronic component 12. In addition, the second heat exchange body 112 has an evaporation end 1121 and a condensation end 1122. The second heat exchange body 112 has a cavity 1123. A cooling medium (not shown in FIG. 2) is disposed in the cavity 1123. The cooling medium may circulate between the evaporation end 1121 and the condensation end 1122. The second electronic component 13 is connected to the evaporation end 1121 in the thermally conductive manner. After heat generated by the second electronic component 13 is transferred to the evaporation end 1121, the cooling medium located near the evaporation end 1121 in the cavity 1123 is evaporated due to the heat, and is condensed due to heat release at the condensation end 1122. In other words, the second heat exchange body 112 implements a heat dissipation function of the second heat exchange body 112 mainly based on the circulation of the cooling medium between the evaporation end 1121 and the condensation end 1122. The housing 14 is connected to the heat conduction part 1111 and the evaporation end 1121, to form an airtight accommodating cavity 110. Both the first electronic component 12 and the second electronic component 13 are located in the accommodating cavity 110, so that airtightness of the first electronic component 12 and the second electronic component 13 can be ensured. In addition, during specific disposition, the first electronic component 12 and the second electronic component 13 may alternatively be connected to the housing 14 in the thermally conductive manner. In other words, the heat generated by the first electronic component 12 and the second electronic component 13 may alternatively be dissipated via the housing 14.

In the example provided in this application, the composite heat exchanger 11 includes two different types of heat exchange bodies, so that different heat dissipation characteristics and heat dissipation effect can be implemented. Specifically, the first heat exchange body 111 dissipates heat mainly based on heat transfer of a material of the first heat exchange body 111. The first heat exchange body 111 may be made of a material with good heat conductivity, like steel, copper, or aluminum. The first heat exchange body 111 has advantages of easy deployment, simple structure, cost-effectiveness, and high reliability. The second heat exchange body 112 dissipates heat mainly based on air-liquid conversion of the cooling medium and the circulation of the cooling medium between the evaporation end 1121 and the condensation end 1122. The second heat exchange body 112 has an advantage of high heat dissipation efficiency. Therefore, the second heat exchange body 112 may be configured to dissipate heat for an electronic component that generates a large amount of heat.

For example, in the charging device 10 provided in this application, a heat flux density of the first electronic component 12 is less than a heat flux density of the second electronic component 13. The heat flux density refers to heat energy passing through a unit area in unit time. In other words, in same time and per unit area, the heat generated by the first electronic component 12 is less than the heat generated by the second electronic component 13. Therefore, during actual application, the heat conduction part 1111 of the first heat exchange body 111 may be connected to the first electronic component 12 in the thermally conductive manner, to dissipate heat for the first electronic component 12, and reduce application costs of the composite heat exchanger 11. The evaporation end 1121 of the second heat exchange body 112 may be connected to the second electronic component 13 in the thermally conductive manner, to dissipate heat for the second electronic component 13, and ensure that the second electronic component 13 is within a normal operating temperature range.

In summary, in the charging device 10 provided in this application, the composite heat exchanger 11 is used, so that deployment difficulty and application costs of a heat dissipation structure can be effectively reduced. In addition, high heat dissipation efficiency can be further achieved, so that a heat dissipation requirement of an electronic component that generates a large amount of heat can be met.

In addition, after the composite heat exchanger 11 is used, the first electronic component 12 and the second electronic component 13 may be disposed in the airtight accommodating cavity 110. This can well protect the first electronic component 12 and the second electronic component 13, and prevent the first electronic component 12 and the second electronic component 13 from being affected by impurities such as dust and water vapor in the air.

It should be noted that the foregoing first electronic component 12 and second electronic component 13 are for ease of differentiation and description. Types of the first electronic component 12 and the second electronic component 13 may be the same or may be different. This is not limited in this application. In addition, during actual application, the charging device 10 may include a plurality of different types of electronic components, to implement a charging function of the charging device 10.

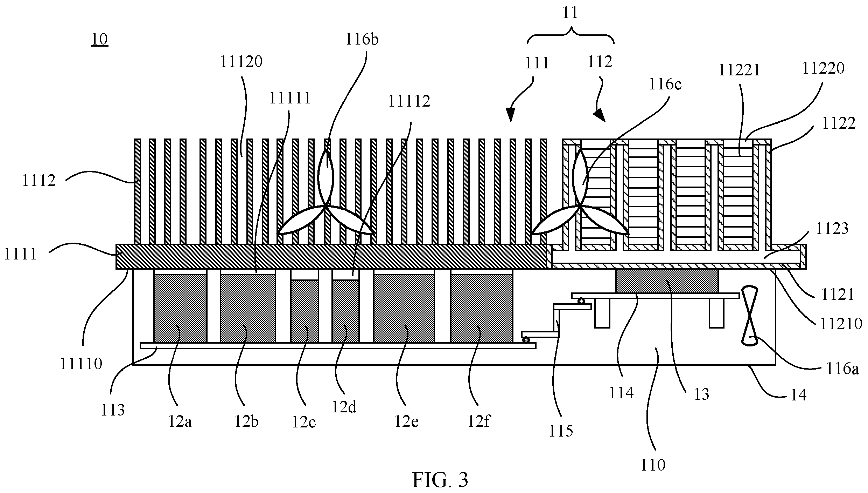

For example, as shown in FIG. 3, a charging device 10 may include a first circuit board 113 and a plurality of first electronic components disposed on the first circuit board 113. Specifically, the plurality of first electronic components may specifically be an inductor 12a, an inductor 12b, a capacitor 12c, a capacitor 12d, a transformer 12e, and a transformer 12f. In addition, the charging device 10 further includes a second circuit board 114 and a second electronic component 13 disposed on the second circuit board 114. The second electronic component 13 may be a power component like an insulated gate bipolar transistor (insulated gate bipolar transistor, IGBT). A specific type of the second electronic component 13 is not limited in this application.

The first circuit board 113 may be a printed circuit board (printed circuit board, PCB), or may be a flexible printed circuit (flexible printed circuit, FPC). In addition, types of the second circuit board 114 and the first circuit board 113 may be the same or may be different. Specific types of the first circuit board 113 and the second circuit board 114 are not limited in this application. During actual application, a conductive connection may be implemented between the first circuit board 113 and the second circuit board 114 through a copper bar 115, a cable, or the like.

In the example provided in this application, the first circuit board 113 and the second circuit board 114 that are independent of each other are used, and all the first electronic components for which heat dissipation is performed via the first heat exchange body 111 are disposed on the first circuit board 113. This helps implement adaptation between the first heat exchange body 111 and the plurality of first electronic components, and facilitates disposition and positioning. Correspondingly, the second electronic component 13 for which heat dissipation is performed via the second heat exchange body 112 is disposed on the second circuit board 114. This helps implement adaptation between the second heat exchange body 112 and the second electronic component 13, and facilitates disposition and positioning. Certainly, in another example, the first circuit board 113 and the second circuit board 114 may alternatively be of an integrated structure, and details are not described herein. In addition, the charging device 10 may alternatively include two or more second electronic components 13. A quantity of disposed first electronic components and a quantity of disposed second electronic components 13 are not specifically limited in this application.

During specific disposition, structure types of the first heat exchange body 111 and the second heat exchange body 112 are diversified.

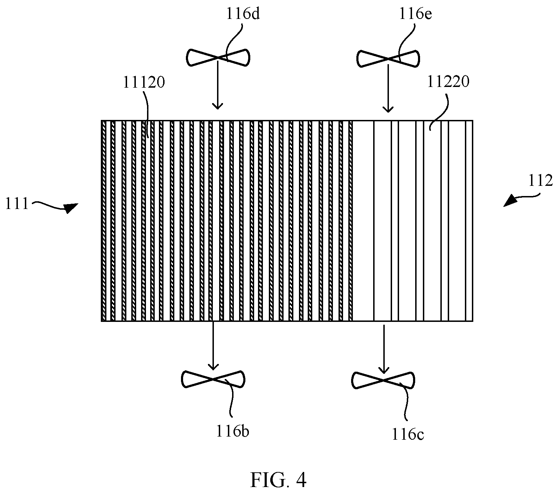

For example, as shown in FIG. 3 and FIG. 4, in an example provided in this application, the first heat exchange body 111 is a serrate teeth heat exchanger. Specifically, the first heat exchange body 111 includes a plate-shaped heat conduction part 1111 and a plurality of fins located on one side of the heat conduction part 1111. The plurality of fins may be understood as a heat dissipation part 1112 of the first heat exchange body 111. A surface that is of the heat conduction part 1111 and that is away from the fins may be used as a first contact surface 11110, and the first electronic component (like the inductor 12a) may be connected to the first contact surface 11110 in a thermally conductive manner. During specific disposition, the inductor 12a may be connected to the first contact surface 11110 in the thermally conductive manner via a thermally conductive material (like thermally conductive silica gel), to ensure thermal conductivity efficiency between the inductor 12a and the first contact surface 11110.

The first heat exchange body 111 may be of an integrated structure or a split structure.

For example, the heat conduction part 1111 and the heat dissipation part 1112 may be integrally formed based on a process like die casting or numerical control machine tool processing. Alternatively, the heat conduction part 1111 and the heat dissipation part 1112 may be manufactured and molded separately, and then the heat conduction part 1111 and the heat dissipation part 1112 are connected based on a process like welding.

In addition, a gap between adjacent fins may form a first airflow channel 11120 for air circulation. When air flows in the first airflow channel 11120, heat of the fins may be taken away. During specific disposition, a gap between fins and a quantity of fins may be appropriately selected based on an actual situation. This is not limited in this application. In the example provided in this application, the plurality of first electronic components are all disposed on a same board surface (for example, an upper board surface in FIG. 3) of the first circuit board 113. Therefore, it is convenient to implement a thermally conductive connection between the plurality of first electronic components 12 and the first contact surface 11110.

In addition, during specific disposition, because height sizes of different types of first electronic components are different, the first contact surface 11110 may be appropriately disposed for different height sizes of the first electronic components.

For example, in the example provided in this application, the first contact surface 11110 has a plurality of protrusions. The first electronic component may be connected to the heat conduction part 1111 in the thermally conductive manner via the protrusions. Specifically, a protrusion 11111 and a protrusion 11112 are used as an example. A height size of the inductor 12b is greater than a height size of the capacitor 12c. Therefore, during disposition, a height size of the protrusion 11111 may be less than a height size of the protrusion 11112, to ensure that the inductor 12b can be well connected to the protrusion 11111 in the thermally conductive manner, and that the capacitor 12c can be well connected to the protrusion 11112 in the thermally conductive manner.

In the example provided in this application, the first heat exchange body 111 has a simple structure and is easy to be manufactured. Therefore, during application, a structural shape of the first heat exchange body 111 may be manufactured to be complex. For example, the protrusion 11111 and another part of the first heat exchange body 111 may be an integrated structure, and may be manufactured based on a die casting process, a cutting process, or the like. Certainly, in another example, the protrusion 11111 may alternatively be an independent mechanical part, and the protrusion 11111 may be fastened to the first contact surface through welding or the like.

In addition, in another example, the protrusion may alternatively be replaced with a groove structure, to adapt to different height sizes of different first electronic components. Details are not described herein again.

During specific application, the second heat exchange body 112 may specifically be a loop thermosiphon (loop thermosiphon, LTS). Specifically, the second heat exchange body 112 is of a hollow thin-wall structure. One end (for example, a lower end in FIG. 3) of the second heat exchange body 112 may be used as an evaporation end 1121. A surface of the evaporation end 1121 may be used as a second contact surface 11210 connected to the second electronic component 13 in the thermally conductive manner. In the example provided in this application, a condensation end 1122 has a plurality of protrusion structures spaced from each other. A second airflow channel 11220 for air circulation may be formed between adjacent protrusion structures. When air flows in the second airflow channel 11220, heat on a surface of the protrusion structure can be taken away. During specific disposition, a gap between protrusion structures and a quantity of protrusion structures may be appropriately selected based on an actual situation. This is not limited in this application.

In addition, in the example provided in this application, there is further a fin 11221 between the protrusion structures, and the fin 11221 may be configured to increase a heat exchange area between the condensation end 1122 and the outside, to help improve heat dissipation performance of the second heat exchange body 112.

When the second heat exchange body 112 is disposed, a capillary structure (not shown in FIG. 3) may be further disposed in a cavity 1123 of the second heat exchange body 112, to improve circulation efficiency of a cooling medium in the cavity 1123, and help improve heat dissipation performance of the second heat exchange body 112.

When the first heat exchange body 111 and the second heat exchange body 112 are disposed, a relative location between the first heat exchange body 111 and the second heat exchange body 112 may be various.

For example, as shown in FIG. 3 and FIG. 4, in an example provided in this application, the first heat exchange body 111 and the second heat exchange body 112 may be disposed in parallel.

Specifically, the first contact surface 11110 of the first heat exchange body 111 and the second contact surface 11210 of the second heat exchange body 112 may be disposed adjacent to each other, and directions of the first contact surface 11110 and the second contact surface 11210 may be approximately the same.

During actual application, a housing 14 may be connected to the first contact surface 11110 and the second contact surface 11210 in an airtight manner, to form an airtight accommodating cavity 110. This improves convenience of connecting the housing 14 to the composite heat exchanger 11.

In addition, a mixed-flow fan 116a may be further disposed in the accommodating cavity 110, so that a hot airflow in the accommodating cavity 110 can circulate and flow, and a problem of an excessively high local temperature is avoided.

In addition, as shown in FIG. 3, in an example provided in this application, the first heat exchange body 111 may alternatively be connected to the second heat exchange body 112 in the thermally conductive manner.

Specifically, the heat conduction part 1111 of the first heat exchange body 111 may be connected to the evaporation end 1121 of the second heat exchange body 112 in the thermally conductive manner, to improve overall heat dissipation efficiency of the composite heat exchanger 11.

For example, when a temperature of the heat conduction part 1111 is higher than a temperature of the evaporation end 1121, heat of the first heat exchange body 111 (or the first electronic component) may be dissipated via the second heat exchange body 112. Alternatively, when a temperature of the evaporation end 1121 is higher than a temperature of the heat conduction part 1111, heat of the second heat exchange body 112 (or the second electronic component 13) may be dissipated via the first heat exchange body 111. Alternatively, it may be understood that heat of the first electronic component 12 may be dissipated via the first heat exchange body 111 and the second heat exchange body 112, so that a heat dissipation function of the composite heat exchanger 11 can be used to a large extent. Correspondingly, heat of the second electronic component 13 may be dissipated via the second heat exchange body 112 and the first heat exchange body 111, to improve heat dissipation efficiency of the composite heat exchanger 11. During specific disposition, the heat conduction part 1111 may be welded to the evaporation end 1121, to implement a fixed connection between the first heat exchange body 111 and the second heat exchange body 112, and implement a thermally conductive connection between the heat conduction part 1111 and the evaporation end 1121.

Certainly, in another example, the first heat exchange body 111 and the second heat exchange body 112 may alternatively be fastened via a connector like a screw. A connection manner between the first heat exchange body 111 and the second heat exchange body 112 is not limited in this application.

It may be understood that, in another example, the thermally conductive connection may not be implemented between the first heat exchange body 111 and the second heat exchange body 112, and details are not described herein again. In addition, during specific disposition, the first airflow channel 11120 and the second airflow channel 11220 may be disposed in parallel or connected.

For example, as shown in FIG. 3 and FIG. 4, in an example provided in this application, the first airflow channel 11120 and the second airflow channel 11220 are disposed in parallel. A fan 116b and a fan 116d may be disposed at two ends of the first airflow channel 11120 respectively, and a fan 116c and a fan 116e may be disposed at two ends of the second airflow channel 11220 respectively. The fan 116d and the fan 116e are of an air blowing type. In other words, the fan 116d may be configured to blow air into the first airflow channel 11120, and the fan 116e is configured to blow air into the second airflow channel 11220. The fan 116b and the fan 116c are of an air extraction type. In other words, the fan 116b may be configured to extract air from the first airflow channel 11120, and the fan 116c may be configured to extract air from the second airflow channel 11220.

In addition, a structure like a flow equalization plate (not shown in FIG. 3) may be disposed between the fans 116b and 116d and the first airflow channel 11120, so that airflow generated by the fan 116b and the fan 116d can flow through each first airflow channel 11120 as evenly as possible.

Correspondingly, a structure like a flow equalization plate (not shown in FIG. 3) may be further disposed between the fans 116c and 116e and the second airflow channel 11220, so that airflow generated by the fan 116c and the fan 116e can flow through each second airflow channel 11220 as evenly as possible.

During specific application, a quantity and locations of the fans may be appropriately set based on different requirements. For example, the fan 116d and the fan 116e may not be disposed. A quantity and locations of the disposed fans are not specifically limited in this application.

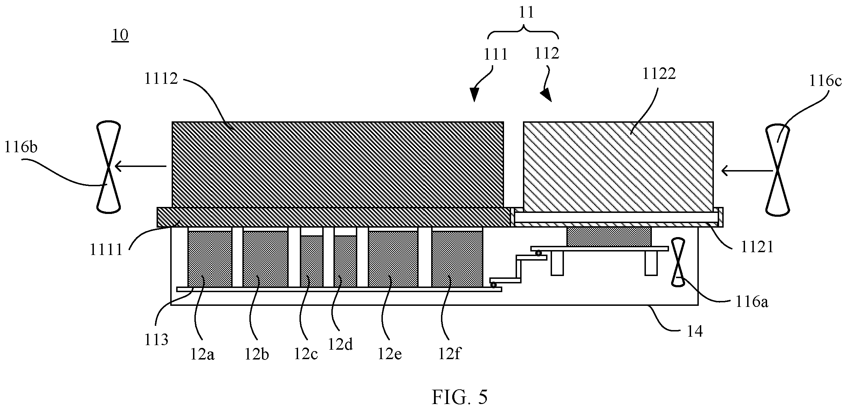

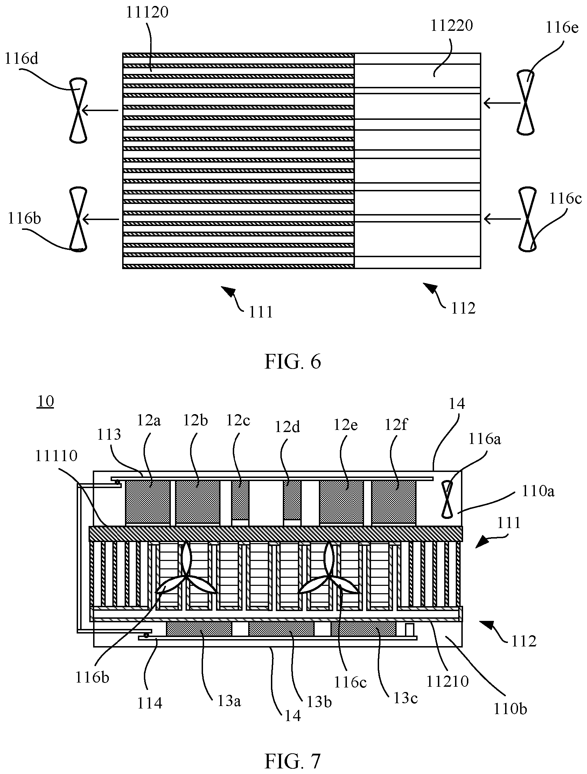

In addition, as shown in FIG. 5 and FIG. 6, in an example provided in this application, the first airflow channel 11120 and the second airflow channel 11220 may be connected. During specific disposition, the first airflow channel 11120 may be located downstream of the second airflow channel 11220. The cooling airflow may first pass through the second airflow channel 11220 to ensure heat exchange efficiency of the second heat exchange body 112, and then pass through the first airflow channel 11120 to perform heat dissipation on the first heat exchange body 111.

It may be understood that, during actual application, the first heat exchange body 111 is generally configured to dissipate heat for an electronic component with a high heat flux density. Therefore, the first heat exchange body 111 needs to have good heat dissipation effect. Therefore, in the example provided in this application, the second airflow channel 11220 is located upstream of the first airflow channel 11120.

Certainly, in another example, the second airflow channel 11220 may alternatively be located downstream of the first airflow channel 11120. During actual application, a relative location of the first airflow channel 11120 and the second airflow channel 11220 may be appropriately set based on an actual requirement, and details are not described herein again.

In addition, the first heat exchange body 111 and the second heat exchange body 112 may be disposed in parallel, or may be disposed in a stacked manner.

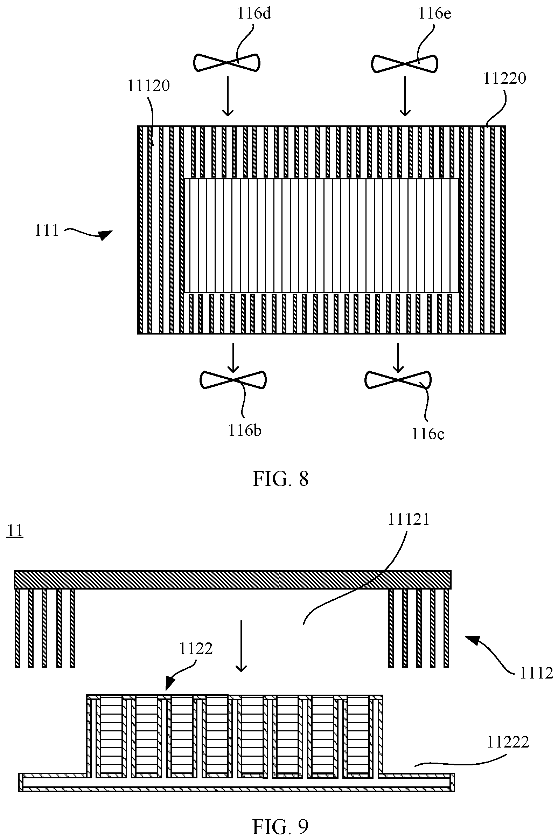

For example, as shown in FIG. 7 and FIG. 8, in another example provided in this application, the first contact surface 11110 of the first heat exchange body 111 and the second contact surface 11210 of the second heat exchange body 112 are disposed opposite to each other.

During actual application, the housing 14 may be connected to the first contact surface 11110 and the second contact surface 11210 separately in an airtight manner, to form two airtight spaces. Specifically, an accommodating cavity 110a is formed between the housing 14 and the first contact surface 11110, and an accommodating cavity 110b is formed between the housing 14 and the second contact surface 11210. The plurality of first electronic components, such as the inductor 12a, the inductor 12b, the capacitor 12c, the capacitor 12d, the transformer 12e, and the transformer 12f, are all disposed in the accommodating cavity 110a, and are connected to the first contact surface 11110 in the thermally conductive manner. The plurality of second electronic components, such as the transistor 13a, the transistor 13b, and the transistor 13c, are all disposed in the accommodating cavity 110b, and are connected to the second contact surface 11210 in the thermally conductive manner. Different electronic components may be separately disposed in different accommodating cavities, and this helps improve flexibility of deploying the different electronic components.

In addition, a mixed-flow fan 116a may be further disposed in the accommodating cavity 110a, so that a hot airflow in the accommodating cavity 110a can circulate and flow, and a problem of an excessively high local temperature is avoided. Certainly, in another example, a mixed-flow fan may alternatively be disposed in the accommodating cavity 110b. This is not specifically limited in this application.

As shown in FIG. 9, in an example provided in this application, the heat dissipation part 1112 has a first recess part 11121, and the condensation end 1122 is located in the first recess part 11121. In addition, the condensation end 1122 has a second recess part 11222, and the heat dissipation part 1112 is located in the second recess part 11222. Alternatively, it may be understood that the first heat exchange body 111 and the second heat exchange body 112 may be disposed in a cross manner, to reduce a volume of the entire composite heat exchanger 11, and facilitate miniaturization of the composite heat exchanger 11.

In the example provided in this application, the first recess part 11121 is located in a middle region of the heat dissipation part 1112. In other words, the first recess part 11121 is surrounded by the fin structures. The second recess part 11222 is located in a peripheral region of the condensation end 1122. Therefore, when the condensation end 1122 is located in the first recess part 11121 and the heat dissipation part 1112 is located in the second recess part 11222, the condensation end 1122 is surrounded by the fin structures of the heat dissipation part 1112.

Certainly, in another example, disposition locations of the first recess part 11121 and the second recess part 11222 and a relative location between the heat dissipation part 1112 and the condensation end 1122 may alternatively be flexibly set based on different requirements, and details are not described herein again.

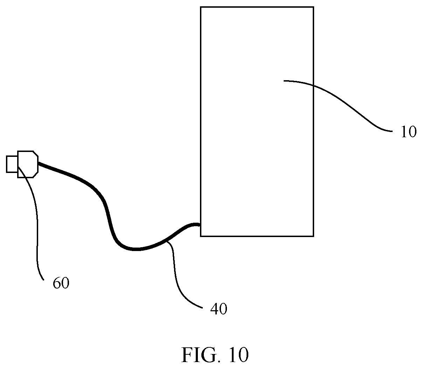

In addition, as shown in FIG. 10, an embodiment of this application further provides a charging system, including a charging terminal 60 and a charging device 10. The charging terminal 60 is connected to an output end of the charging device 10 through a cable. During specific application, the charging device 10 may perform processing like frequency conversion on an alternating current in a power grid, or may convert an alternating current into a direct current and then provide the direct current to the charging terminal 60. The charging terminal 60 may be connected to a powered device (for example, a vehicle), to supplement electric energy to the powered device. The charging terminal 60 may be in a form of a charging connector or the like. In addition, one charging device 10 may be connected to one charging terminal 60, or may be connected to a plurality of charging terminals 60. A quantity of charging terminals 60 is not limited in this application.

During specific disposition, the charging device 10 may be disposed on the ground, or may be disposed at a location like on a wall. A specific disposition location and form of the charging device 10 are not limited in this application.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment. "A plurality of" in this application refers to two or more than two. "And/or" describes an association relationship between associated objects, and indicates that three relationships may exist. For example, A and/or B may indicate the following three cases: A exists alone, both A and B exist, and B exists alone, where A and B may be singular or plural. It may be understood that various numbers in embodiments of this application are merely used for differentiation for ease of description, and are not used to limit the scope of embodiments of this application. The sequence numbers of the foregoing processes do not mean execution sequences, and the execution sequences of the processes should be determined based on functions and internal logic of the processes.

## Claims

1. A charging device, comprising:
a composite heat exchanger, comprising a first heat exchange body and a second heat exchange body that are fastened, wherein
the first heat exchange body has a heat conduction part and a heat dissipation part; and
the second heat exchange body has an evaporation end and a condensation end, the second heat exchange body has a cavity, a cooling medium is disposed in the cavity, and the cooling medium may circulate between the evaporation end and the condensation end;
a first electronic component, connected to the heat conduction part in a thermally conductive manner;
a second electronic component, connected to the evaporation end in the thermally conductive manner, wherein a heat flux density of the first electronic component is less than a heat flux density of the second electronic component; and
a housing, connected to the heat conduction part and the evaporation end, to form an airtight accommodating cavity, wherein
both the first electronic component and the second electronic component are located in the accommodating cavity.

2. The charging device according to claim 1, wherein the heat conduction part is connected to the evaporation end in the thermally conductive manner.

3. The charging device according to claim 1 or 2, wherein the heat conduction part has a first contact surface, and the evaporation end has a second contact surface; and
the first electronic component is connected to the first contact surface in the thermally conductive manner, and the second electronic component is connected to the second contact surface in the thermally conductive manner.

4. The charging device according to claim 3, wherein the first contact surface and the second contact surface are disposed adjacent to each other, and the first contact surface and the second contact surface face a same direction.

5. The charging device according to claim 3, wherein the first contact surface and the second contact surface are disposed opposite to each other.

6. The charging device according to claim 5, wherein the heat dissipation part has a first recess part, and the condensation end is located in the first recess part.

7. The charging device according to claim 5 or 6, wherein the condensation end has a second recess part, and the heat dissipation part is located in the second recess part.

8. The charging device according to any one of claims 3 to 7, wherein the first contact surface has a groove or a protrusion, and the first electronic component is connected to the groove or the protrusion in the thermally conductive manner.

9. The charging device according to any one of claims 1 to 8, wherein the heat dissipation part has a first airflow channel, and the condensation end has a second airflow channel.

10. The charging device according to claim 9, further comprising a fan, wherein
the first airflow channel is connected to the second airflow channel;
the fan is configured to accelerate a flow speed of air in the first airflow channel and the second airflow channel; and
the first airflow channel is located downstream of the second airflow channel.

11. The charging device according to claim 9, further comprising a first fan and a second fan, wherein
the first airflow channel and the second airflow channel are arranged in parallel;
the first fan is configured to accelerate a flow speed of air in the first airflow channel; and
the second fan is configured to accelerate a flow speed of air in the second airflow channel.

12. The charging device according to any one of claims 1 to 11, wherein the first electronic component and the second electronic component are connected to the housing in the thermally conductive manner.

13. A charging system, comprising a charging terminal and the charging device according to any one of claims 1 to 12, wherein the charging device has an output port, and the charging terminal is connected to the output port.
